(19) Europäisches Patentamt
European Patent Office
Office européen des brevets

(11) **EP 2 889 925 A1**

(12) **EUROPEAN PATENT APPLICATION**
published in accordance with Art. 153(4) EPC

(43) Date of publication:
**01.07.2015 Bulletin 2015/27**

(51) Int Cl.:
***H01L 35/32*** *(2006.01)*

(21) Application number: **12883142.7**

(22) Date of filing: **21.08.2012**

(86) International application number:
**PCT/JP2012/071529**

(87) International publication number:
**WO 2014/030264 (27.02.2014 Gazette 2014/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Mabuchi, Mahito**
**Kyoto-shi 600-8096 (JP)**

(72) Inventor: **ASHIDA, Yu**
**Kyoto-shi**
**Kyoto 601-1122 (JP)**

(74) Representative: **Müller Hoffmann & Partner**
**Patentanwälte mbB**
**St.-Martin-Strasse 58**
**81541 München (DE)**

(54) **THERMOELECTRIC CONVERSION ELEMENT INCLUDING IN THERMOELECTRIC MATERIAL SPACE OR SPACE IN WHICH CONNECTION IS MADE SUCH THAT HEAT TRANSFER AMOUNTS ARE REDUCED AND WORKING SUBSTANCE FLOW IS EQUAL TO OR GREATER THAN THAT FOR ORIGINAL THERMOELECTRIC MATERIAL**

(57) The purpose of the present invention is to improve, by providing, in the terminals of thermoelectric materials and electrodes or the inside of the material, one or more spaces or either thin or fine line structures in spaces such that heat transfer or working substance (WS) flow is prevented from propagating, figure-of-merit of thermoelectric materials without the same. Thermal conductivity due to causes other than WS that can move within a thermoelectric conversion element can be reduced as much as possible by providing the spaces, alternatively, microstructures in thermoelectric materials. If the terminal of thermoelectric material or surfaces facing the terminal of the thermoelectric material is modified and/or the steeple tips or steeples formed on the terminal, the potential barrier height for WS can be reduced or the tunnel potential barrier width can be reduced when WS leaps into the space from the surface of the steeple tips or the steeples. The direct heat transfer amount caused by the lattice between both ends that sandwich the space is reduced without changing the current flow rate due to WS being reduced, and thus the thermoelectric performance of the thermoelectric conversion element that includes in thermoelectric materials the spaces and/or bridging spaces in which a connection is made can be made greater than the figure-of-merit of conventional thermoelectric materials that do not include any spaces.

FIG.1

**Description**

Technical Field

The present invention relates to conversion method between thermal energy and electrical energy.

Background Art

Power generation system converting thermal energy into electrical energy includes thermoelectric power generation system using thermoelectric material or thermionic system. In reverse process of using thermoelectric material as thermoelectric system, thermoelectric material is also used as cooling system. The thermoelectric materials are the materials that are used current transport phenomena with respect to both electric current and heat transfer amounts. And in the system can be analyzed by the classical mechanics, working substance having role in the electric current of the current transport phenomena is classical working substance such as electrons, holes and so on and in quantum effects becoming mainly significant in case at cryogenic temperature, the working substance is quantum working substance. And in wide range of electrical conductivity from metals to insulators electric, the current transport phenomena has been utilized. The thermoelectric material in which electric current amount is larger compared with heat transfer amount is good thermoelectric performance one.

Performance of thermoelectric material in which electrons or holes are the classical working substance is usually defined as figure-of-merit **Z**.

equation. 1

$$Z = S^2 / \kappa \rho$$
,

The larger value of dimensionless figure-of-merit ZT (where T is the absolute temperature) of thermoelectric material is, the better performance of its convertor between thermal and electrical energy is. Here S represents Seebeck coefficient, $\kappa$ is thermal conductivity of sum of thermal conductivity $\kappa_c$ of the classical working substance and lattice thermal conductivity $\kappa_{ph}$, and $\rho$ is the electrical resistivity of thermoelectric material. In order to enlarge ZT without changing temperature, it is enough that the value of S is made large and those of $\kappa$ and $\rho$ are made small. Because these electric heat characteristics are functions of density of the classical working substance in thermoelectric materials, S and $\rho$ are small and $\kappa$ is large in the case that density of the classical working substance is high. According to theory of semiconductor, optimum density of electrons or holes for a working temperature range of thermoelectric material exists in order to have good performance.
To improve the thermoelectric performance with respect to density, following three ways can be considered as:

  1) Increase the density of the electrons or holes, and reduce $\rho$.
  2) Reduce $\kappa_{ph}$, since $\kappa_c$ is proportional to $1/\rho$ from the Wiedemann-Franz law.
  3) Increase S, by using thermoelectric material with large effective mass of electron or hole.

Above mentioned ZT is derived from using thermal equilibrium transport theory with respect to heat transfer amount and electric transfer amount in thermoelectric materials. This theory can be extended to the quantum working substance.
It is for thermoelectric material to be desirable that S is large, $\kappa$ is small similar to that of insulator and moreover $\rho$ is small similar to that of metal. Such thermoelectric materials are manifested in 'a Phonon Glass and an Electron Crystal'; which aims at high migration materials that behave like crystal for both electron and hole moving, but like glass for lattice vibration. Such materials are found among degenerating compounds or their solid solutions that density of the classical working substance is high, in addition reducing thermal conductivity due to $\kappa_{ph}$ is connected to high performance of thermoelectric materials.
According to non-patent literature 1, in case that the length is shorter than mean free path of phonons in $Bi_2Te_3$, the phonons along to the direction propagates ballistically. In case that heat transfer occurs parallel to the direction of length of the fine wire, phonon motion is characterized whether the length or the diameter of the fine wire are longer or shorter than the mean free path of the phonon. If the length and the diameter of the fine wire are longer than the mean free path of the phonon, the heat transfer is diffusive phonon according to the Fourier's law. If the diameter of the fine wire is less than the mean free path of the phonon, the phonons move ballistically in the diameter. But due to roughness of the surface of the fine wire, the heat transfer is smaller than that characterized by diffusive motion of the phonon. In case that the length of the fine wire is shorter than the mean free path of phonon and that the phonon motion is less affected by roughness of surface of the fine wire, the phonon also conducts ballistically along the length of the fine wire so that heat transfer in direction of the length is greater than that characterized by diffusive motion of phonon. On the other hand, using non-equilibrium molecular dynamics simulations, dependence of heat transfer on diameter of nanotube is evaluated in non-patent literature 2. In single layered nanotube, roughness of the both surfaces is reduced so that phonon along the direction of the length moves ballistically up to 1.6$\mu$m at room tem-

perature. As a result, length of heat transfer due to the phonon is enlarged that characterized by diffusive phonon motion. In geometrical low-dimension of thermoelectric material or layered thermoelectric materials, cross section area in the direction of the thickness, through which electrons move, becomes so narrow that energy interval between electron states enlarges much more than thermal energy. Examples of thermoelectric device based on the fact that figure-of-merit is improved due to geometrical low-dimension or layered thermoelectric materials are nano-sheet, super-lattice, nano-wire and so on.

Currently intermetallic compound, such as bismuth telluride or silicide-based materials are used as thermoelectric material. Layered cobalt oxides, cage-structured compounds such as clathrates, and materials having strongly correlated carrier are also used as new thermoelectric material. The highest working temperature of PbTe-based compounds is about 950K. The maximum Z is $1.7 \times 10^{-3} K^{-1}$ at around 450K, in which electron density of n-type PbTe-based compounds is $5 \times 10^{25} m^{-3}$. Increasing the electron density makes the maximum Z gradually reduce in proportion. In case that $7 \times 10^{25} m^{-3}$, the maximum Z reduces to $1.2 \times 10^{-3} K^{-1}$ at around 800K. PbTe-based compounds can be used in thermoelectric device in a wide temperature range of 300K to 950K.

Generation of electric power that takes advantage of electrons moving in space between electrode terminals is thermionic generation of electricity. The generation utilizes the fact that the electrons from emitter of the electrode terminal at high temperature are emitted by thermal energy. In the generation, electrons may inhibit the electron emitting from the emitter due to space-charge limited current. To reduce an influence of the space-charge, there are one method by using cesium and the other method by using narrower distance between the terminals than a few micrometers. Cesium prevents from the space-charge limited current and increases difference between values of work functions at both emitter and collector terminals in order to increase electromotive force. In the space, however, the energy of electrons is lost due to elastic or non-elastic collisions between the electrons or between the electrons and cesium nucleus. Distance between terminals that is 0.1mm is used in the universe.

A radiational heat transfer type of thermoelectric conversion system, which has insulating film or space in order to permit heat transfer without permitting electric current, is used. A pair of n-type and p-type semiconductors forming into module contacts with wall of either hot or cold reservoirs through insulating film or the space. In the module, electric circuit directly connects with thermoelectric materials, electrodes and so on.

In case that direction of heat transfer is parallel to that of electric transfer each other, a system is described as a cooling system in patent literature 1 or patent litarature 2. In these systems electric power is always supplied externally so that the electric current flows through the space, and consequently heat transfer accompanying with the electric current also flows through semiconductors.

In mechanical alloying process as expressed in patent literature 3, ZT of thermoelectric materials is improved by forming polycrystal of the thermoelectric materials without changing chemical composition. Improving the above process of using polyvinyl alcohol as a binder, pressing powder of iron silicide and removing a polyvinyl alcohol by heating after pressing, patent literature 4 is aimed to reduce production costs by amorphous structure film created by sol-gel process or by dry film fabrication process. According to patent literature 5, spark plasma sintering prevents thermoelectric materials from re-crystallization.

In order to increase *ZT* of thermoelectric materials by decreasing thermal conductivity without reducing electric conductivity, according to non-patent literature 3, after crushing crystal made from BiSbTe into dozens of nanometers in argon, hot-pressing is conducted. Intermediate structures between amorphous and crystalline are formed at low cost so that 40% improvement is achieved and *ZT* becomes 1.4. In patent literature 6, in order to prevent heat transfer and to allow electric current, the thermoelectric devices that lattice vibration is extremely decreased by substantially no grain boundary made of glassy solid between polycrystals, made from each grain sizes about or less than 100nm. Using "room temperature impact consolidation" by method of aerosol deposition, the thermoelectric devices consisting of essentially cage-structured polycrystalline is formed on substrate crystal.

It is determined by potential against working substance how working substance moves through space between constituents. Near interface of the space, the potential becomes lower due to electric mirror image effect. The potential is obtained by simulation or analytical method like in case of non-patent literature 4.

Working substance can move into the space from the interface of the space by the fact that working substance must go over the potential barrier with thermal energies, electromagnetic energies or etc., or tunnel through. In thermionic emission, the emission current amount from the interface are connected to work function by formula of Richardson-Dushman. In case of field emission of electron, the current tunneling through the potential can be also connected with field intensity by formula of Fowler Nordheim, etc. Amount of working substance flow discharging from the interface is determined by tunneling probability, thermal energy or electromagnetic waves in the interface, etc. In case of the inter-surface irradiated with laser, the amount of working substance flow is decided by intensity of laser irradiation. In the case that current density in the space exceeds $1 \times 10^{10} A/m^2$, amount of electric space-charge due to field emission in the space will become large and the amount of working substance flow under the space-charge restriction could not increase and then ZT worsens (non-patent literature 5). The shorter width of the space is, the better efficiency of the thermoelectric materials with the space is achieved.

A nuclear cell is a device as energy of radiation transforms into electric power. It can classify whether or not thermal energy associated with nuclear decay is used. The device that uses the thermal energy is thermoelectric conversion system or thermion conversion system. Without using thermal energy, electromotive force is gained by a system in that p-n junction of semiconductor is irradiated by radiation.

In thermoelectric generation using radioisotope, electricity is generated using the thermal energy generated at that time in either the collection part of the radiation particle beam or decay heat of a portion including a radioactive isotope using a radiation particle beam in the process of natural decay of radioactive isotopes.

In order to assemble thermoelectric materials into a module, it is necessary to join themselves each other. Examples of the method of joining are solder bonding method, thermal pulse method (thermal plasma spraying method), physical vapor deposition method, welding process, electroplating method (chemical vapor deposition), pressure contact method, diffusion bonding method, fired ceramic thick film method (joint assembly method) or other joining method. In the solder bonding method, diffusion of solder material in use causes degradation. The fired ceramic thick film method often produces physical defects due to oxygen impurities or contamination in joint interfaces. In addition to bondings, a thermal stress generates in bonding interfaces, and then substantially influences durable years of thermoelectric device.

In accordance with temperature range and heat transfer amount to be worked, system using thermoelectric materials must be optimized by selecting a type, geometrical shape and size of the thermoelectric materials, and type and thickness of thermal insulator around them. Heat may radiate by use of air cooling fins, air cooling fins with fan, or water-cooling, and heat exchange with the other structures must be also taken into consideration. Thermoelectric material is attached to electrodes and structures by grease, adhesive and solder. Sealing with an epoxy resin, a silicon resin and so on prevents from moisture intrusion, electrochemical dissolution of solder or diffusion of grease, adhesive, etc. to module inside the system. The more heat transfer occurs from the high-temperature between the low temperature portions of the module with use of such greases and sealants, the more performance of system worsens.

Output power of thermoelectric generation P is expressed as:

equation. 2

$$P = \frac{S^2 (T_H - T_C)^2 m}{R (m + 1)^2},$$

where, $T_H$ and $T_C$ are respective high and low temperature of heat reservoirs. $m = R_L/R$, here $R$ and $R_L$ are internal resistances and resistance of external load, respectively. Influence of electric contact resistance $R_c$ at junctions between an electrode and thermoelectric material, or between different kinds of thermoelectric materials and so forth, on module efficiency of thermoelectric generator η is expressed as:

equation. 3

$$\eta = \eta_c \frac{M - (1 + \delta)}{M + (1 + \delta)\left(T_c/T_H\right)},$$

where

equation. 4

$$\eta_c = \frac{T_H - T_C}{T_H},$$

$$M = \{1 + Z (T_H - T_C)/2\}^2$$

$$\delta = R_c/R.$$

According to non-patent literature. 6, resistance $R_{\text{Bi2Te3}}$ of $Bi_2Te_3$ alloy, which is based on thermoelectric device manufactured in the form of cross section area $A$ and height H with an electrochemical deposition method on a place where Cu/Ni electrode is metalized on $Si/SiO_2$ substrate, equals $\rho_{\text{Bi2Te3}} A/H$, then $P$ is proportional to $H/A$. Where, $\rho_{\text{Bi2Te3}}$ is resistivity of $Bi_2Te_3$. It has been reported that required cross section of the area decrease and power density increase when $H$ is made small in nano size from micro size under fixed $H/A$. As a practical application, $P$ is about $10\mu W$ by difference in temperature between a human body and the atmosphere.

Some of those thermoelectric modules are π-shaped modules consisting of a pair of different polarities p-type and n-type sandwiched between electrodes. Internal resistance of the module $R^{mod}{}_i$ and thermal conductivity $\kappa^{mod}$ are dependent on a length and cross sectional area of pair of different polarities. Module figure-of-merit $Z^{mod}$ is

equation. 5

$$Z^{mod} = S^{mod} / R^{mod}{}_i \kappa^{mod}$$

$R^{mod}{}_i$ and $\kappa^{mod}$, which are optimized, with respect to ratio length to cross sectional area in the rectangular shape of thermoelectric material and with respect to number of $\pi$-shaped modules, by the use of the coefficient of performance $\Phi$ ($Q_c/P$ at cooling system or $Q_h/P$ at generating system) due to making Joule heat generating and energy loss in irreversible process due to heat emission release to surroundings reduce. Where $Q_h$ and $Q_c$ express heat transfer amounts from hot and cold reservoirs, respectively, and $P$ represents electric power. And, ceramic basis as an insulator is used in some module or is not used in others (skeleton type). Through geometrical size of the basis and temperature difference between the heat reservoirs, in a module of ceramic basis, the heat stress which arises in a thermoelectric module inserted between hot and cold reservoirs becomes larger in the ceramic basis than the basis of skeleton type. Development of segment heterozygous thermoelectric modules, in which heat reservoir and insulator, insulator and electrode, and several compositions of different heterogeneous thermoelectric materials are piled up in series with parallel to the heat transfer by the best partition of temperature range with respect to ratio of compositions and impurity concentration, makes heat-proof improve by optimizing durability against thermal stress generated at the interfaces. Such as a segment element, by optimizes efficiency and heat cycle resistance

Electrodes coated by insulator in contact with heat source and with another different heat source are in a pair. Between these electrodes, system is configured in units of $\pi$-shaped modules. For example, all legs of many $\pi$-shaped modules having same polarity of thermoelectric materials are arranged in order on a coated electrode in order to increase output current in generation of electric power. On the other hand, neighboring pair of $\pi$-shaped modules are turned upside down each other and series arrangement located up and down and the neighboring pairs having different polarity of thermoelectric materials are attached on each coated electrode in order to increase output voltage, and composite arrangement of above configurations are present. Thus many $\pi$-shaped modules are assembled from heat reservoir, electrodes, and different polarities of thermoelectric materials. In order to improve efficiency of those $\pi$-shaped

modules, figure of merit of thermoelectric materials must be changed. In such case, cross sectional area and length of thermoelectric materials in $\pi$-shaped modules may differ from each other. Systems of thermoelectric generation of electricity acquire heat transfer amount $Q_{in}$ from a certain heat source, give it to thermoelectric modules, and it flowing in thermoelectric materials is emitted to another heat source with the quantity of heat $Q_{out}$.

For these duration the electrical power P obtained acts to external parts. Thus,

equation. 6

$$\pm P = Q_{in} - Q_{out} .$$

(+ represents the case of power generation by the Seebeck effect, - represent the case of cooling system by the Peltier effect) The system performance $\eta$ is:

equation. 7

$$\eta = P / Q_{in} = 1 - Q_{in} / Q_{out} .$$

To maximize $\eta$ the following is taken into account,

1) To balance the target performance and ability of the module to be used.
2) To maximize performance of single modules somewhat economically.

For example, system efficiency of power generation $\eta_{gen}$ is

equation. 8

$$\eta_{gen} = 1 - Q_h / Q_c .$$

Using the ratio m= $R_c/R_i^{mod}$ of external resistance $R_c$ in external work to internal resistance $R_i^{mod}$ of module, m must be optimized so as to maximize $\eta_{gen}$. It is known that maximum efficiency $\eta_{gen}$ is determined only by temperature conditions and physical properties i.e. figure-of-merit of thermoelectric materials. On the other hand, cooling system efficiency $\eta_{re}$ is expressed as

equation. 9

$$\eta_{re} = 1 - \frac{Q_c}{Q_h} \ .$$

m must be optimized so as to maximize $\eta_{re}$ As a result, working substance flows into $R_0$ is minimized, and then P is minimized.

Citation List

Patent Literature

Patent Literature 1: US 2005/0016575 A1

Patent Literature 2: JPA 2009-21593

Patent Literature 3: JPA H09-55542

Patent Literature 4: JPA H10-27927

Patent Literature 5: JPA H10-41554

Patent Literature 6: JPA 2007-246326

Non Patent Literature

Non Patent Literature 1: Phys. Rev. B, 47 (1993) 16631

Non Patent Literature 2: Jpn. J. Appl. Phys. 47 (2008) 2005

Non Patent Literature 3: Poudel, B. et al., "High-Thermoelectric Performance of Nanostructured Bismuth Antimony Telluride Bulk Alloys", Sience, vol.320, no.5876, pp.634-638, May 2008

Non Patent Literature 4: Jpn. J. Appl. Phys. 48, 098006(2009)

Non Patent Literature 5: Appl. Phys. 33, 2917(1962)

Non Patent Literature 6: J. P. Fleurial, G.J.Snyder, J.A.Herman, P.H.Giauque, W.M.Phillips, M.A. Ryan, P.Shakkottai, E.A.Kolawa and M.A.Nicolet, 18th International Conference on Thermoelectrics (1999)

Summary of Invention

Technical Problem

It is desirable in thermoelectric materials that thermal conductivity should be low as an insulator and moreover electrical resistance should be low as a metal, but electrical resistivity and thermal conductivity depend mutually. So difficulties in development of good thermoelectric materials are caused. The purpose of the present invention is to improve efficiency of thermoelectric system by bridging spaces or fine line.

Solution to Problem

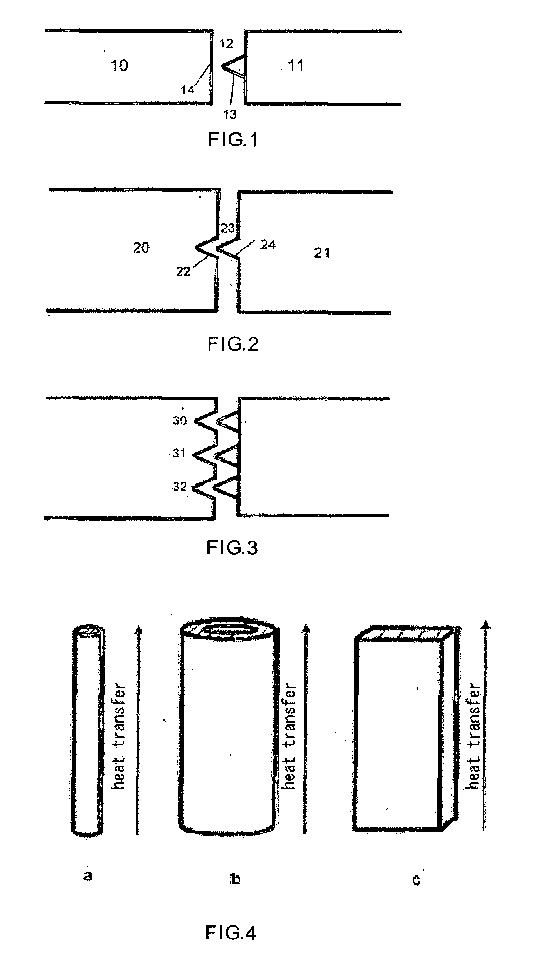

As shown in Fig. 1, a space 12 of sub-micron meter width is arranged between thermoelectric materials 10 and 11 so as to prevent heat transfer in a direction of the heat transfer and working substance flowstream. A characteristic feature of the claim 1 is that the amount of working substance flow in 12 is almost equal to or maintaining higher than those in 10 and 11 of two left and right, and, however, reducing the heat transfer caused by quasi-particle such as lattice vibration, magnon, or spin wave, thermal fluctuation of heat source, and quantum fluctuations at low temperatures improve efficiency of thermoelectric system.. In the space 12 between the terminals of the thermoelectric materials 10 and 11 in Fig.1, the distance from a surface of a steeple tip 13 on the terminal of 11, to confronting terminal surface 14 is described as "distance" $L_{max}(T)$ being dependent on the absolute temperature T at the surface 13. In case that a distance is larger than $L_{max}(T)$, the heat transfer amount by phonons becomes almost negligible in the space 12. In addition, $L_{max}(T)$ of a spin wave or magnon and so on is much smaller than $L_{max}(T)$ of lattice vibration. $L_{max}(T)$ can be estimated from some actual measuring range of the distance between the measurement surface and atom force microscope. Furthermore, sub-micron meter width for 12 makes it possible to avoid the space-charge restriction. By making the width of 12 close to $L_{max}(T)$ from sub-micron meter, the amount of working substance flow through 12 can be enlarged. From here, the space which contains more than one in above-mentioned structures so as to prevent heat transfer or working substance transfer through the space is abbreviated as Space. Either of thermoelectric material 10 or 11 could also be changed into one of good conductors for working substance except for thermoelectric materials. During running time, the energy loss of radiant heat from the space 12 is dependent on temperature difference between the surface 13 and the terminal 14 and on the areas facing. In the case that the distance between 13 and 14 is larger than $L_{max}(T)$ and is shorter than sub-micron meters, the temperature difference between the terminals of the thermoelectric materials, or between the terminal of the thermoelectric material and the terminal of electrode is about several kelvins, so that essentially no radiant heat energy lose occurs. Moreover, the space 12 is evacuated so that heat transfer by convection can be almost suppressed therein. Although heat transfer in metals is a main ingredient of conductivity of heat $\kappa_c$ due to the classical working substance, in the case of a semiconductor, heat transfer caused by ingredient of $\kappa_{ph}$ due to lattice vibration becomes larger Using difference of a physical conducting phenomenon between $\kappa_{ph}$ and $\kappa_c$ in Space, zero $\kappa_{ph}$, and to reduce $\kappa_c$ is aimed.

In case that $\kappa_{ph}$ component is as same as $\kappa_c$ component, that heat transfer caused by phonon is suppressed, and that other parameter is not to change, the figure-of-merit in equation. 1 will easily become twice. In some thermoelectric materials having large figure-of-merit, $\kappa_{ph}$ component is as large as that of $\kappa_c$ component.

Accompanying drawings, which are incorporated in the present specification and are one of construction of the specification, schematically illustrate one or more practicable examples according to principle of the present invention. In the drawings of general idea for the principle the essence of invention is emphasized.

By putting Space into thermoelectric materials, there is a possibility that working substance flow may be mainly obstructed in generation of electric power. Working substance is emitted from the surface by using heat, electric fields, or external electromagnetic waves, etc. In the case that working substance moves from the thermoelectric material 11 to 10 in Fig. 1, working substance in Space is excited by thermal energy and so on in the terminal 14 and the surface 13 of the respective thermoelectric materials, or working substance therein tunnels through the potential barriers in the surfaces 13 into 12 and then moves into the thermoelectric material 14. According to macroscopic quantum mechanics, transmission probability of the tunnel potential barrier for working substance at the inter-surface 13 decreases exponentially as mass of working substance increases, but the fluctuation is suppressed when it is operated at cryogenic temperatures so that $L_{max}(T)$ becomes much narrower, and then the thermoelectric conversion element for working substance with large masses like ion may become practicable because the distance between terminals 13 and 14. Generally for a hole and an electron in semiconductor, mass of the hole is several times mass of the electron. As a result, when the ends of the space 12 separates to some extent, even in p-type semiconductor electrons tunnel through rather than holes do. In the case that thermoelectric material 11 is semiconductor and that steeple tip 13 is metal, junction between the terminal 11 and the steeple tip 13 is more desirable to be ohmic contact in electric power generation and Schottky contact in operation of cooling system.

In applying voltage to Space, a height of either the steeple tip is more high, a distance between the surface 13 and 14 is reduced nearer to $L_{max}(T)$ from a larger distance than $L_{max}(T)$ and a radius of curvature of convex surface 13 at Fig. 1 is reduced less, then the strength of electric fields more increases, and then the thickness and height of potential barrier for working substance at vicinity of the surface 13 is greatly reduced. At vicinity the head of convex of the surface 13, maximum electric field $E_{convex}$ occurs, and is described as $E_{convex}=\beta E_s$, using the enhancement factor $\beta$ that is

depended on the width between the surface 13 and the terminal of 14 and on the radius of curvature of convex surface 13. Here $E_s$ is the electric field of vicinity of plane surfaces in case of both radiuses of curvature of convex surfaces, where working substance is emitted or absorbed, being infinity. In order for working substance to tunnel through, $E_{convex}$ must be larger than $10^9$[V/m]. Reducing the radius of curvature of surface 13, enlarging the height of the steeple tip and reducing the width of the space between 13 and 14, $E_{convex}$ increases. The electric current through the space 12 is dependent on the area of 13 working substance emitted and on the strength of $E_{convex}$, with kind of working substance, with thermal excitation of working substance, field emission, optical excitation of working substance and so on and with distribution of the space charge in the space 12.

In the case that the strength of the electric filed which arises in the space 12 of Fig. 1 cannot be enlarged enough to the required value, or that working substance flow through 12 is small, if a recipient surface of working substance 22 is modified into shape which surrounds over the surface 24 as shown in Fig. 2, then the maximum electric field $E_{convex}$ enlarges before the modification and more area of surface where working substance emits increases. Or the modified shape of the recipient surface may have other sharp pointed corners near the surface 24 so that electric filed at the corners might be maximum in growing form. As a result, emitting flow of charged carrier increases. In this manner, the shapes of the surfaces 22 and 24 are modified so that working substance flow through 23 due to field emission of charged particles i.e. working substance closes as much as possible to or is over working substance flow in each thermoelectric material 20 and 21, and then those could make the figure-of-merit as shown equation. 1 enlarge. In case of working substance flow being small, many steeple tip structures 30, 31 and 32 that are in parallel to each other as shown in Fig. 3 improve to increase the flow.

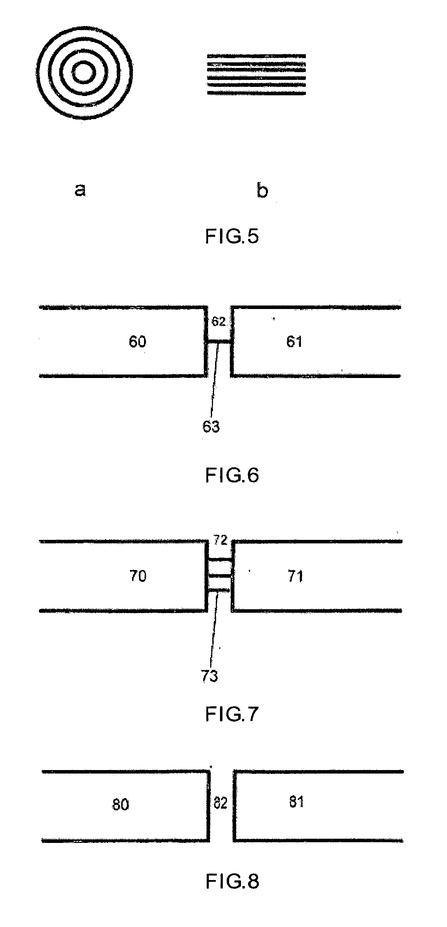

The fact that electromotive force generates by temperature gradient of thermoelectric materials 10 and 11 in Fig. 1 is utilized for working substance flow through the space 12, forces to make working substance move into the space 12 due to electric field determined from the voltage occur without external electric power supply. If the steeple is made from thermoelectric material, a voltage due to the steeple also adds to the voltage of 10 and 11, and then figure-of-merit in equation. 1 enlarges. When the width between the terminals of 10 and of 11 increases, the height of the steeple should be enlarged and temperature difference between 13 and 14 in Space also increases. In the case that the steeple is made from thermoelectric materials which consist of an aggregate of the crystalline whose scale is about tens nano meters or that shape of the steeple is controlled by the geometrical dimension of thermoelectric material and as well as in the case that aggregation of the tow formers are used in the steeple, value of the maximum electric field $E_{convex}$ becomes larger than that without the case of thermoelectric material being ingredient for the steeple, and moreover working substance flow increases so that the figure-of-merit in equation. 1 is more improved. Spatial dimension of thermoelectric materials for the steeple can be in one dimension (Fig. 4a) or two dimensions (Fig. 4b, c) or layered form (Fig. 5).

In Fig1 values of potential and kinetic energies of working substance differs from each other according to working substance moving through the space 12, in the ether thermoelectric materials or conductor 10 and 11, in the surface 13 or in the terminal 14. And there is a possibility that the kind of working substance itself may change. In the case that working substance moves in the direction from 11 to 10, working substance emitted from the surface 13 takes heat from the thermoelectric material 11. On the other hand, working substance moves in the space 12 and reaches the terminal 14, then the energy difference of working substance between in the space 12 and in the material 10 is released as energies such as heat and so on. Using the heat generated during this terminal, it is possible to increase electromotive force of the thermoelectric material 10 using the thermal energy generated during above process.

In the case that working substance moving through the space 12 of Fig. 1 has passed through the surface of the thermoelectric material and is going to pass, the surface 13 and the terminal 14, or a terminal of electrode, the energy of working substance is dissipated to surface states of working substance near these terminals and surfaces by tunnel friction at the tunnel penetration through these terminals and surfaces so that the amount of working substance flow conducting through the space 12 increases. Working substance moving through the thermoelectric materials or through the space has momentum parallel to the direction of working substance flowstream. On the other hand, the friction energy loss due to the dissipation of the energy of working substance to these surface states of facing surfaces each other decreases, it is possible to increase the amount of working substance flow further by the use of this momentum parallel to the direction of working substance flowstream.

Diffusion solid atoms, decreases due to the space12, at especially high temperature mutual solid atomic diffusion cross the interfaces between the thermoelectric materials or electrode is reduced and, moreover, the internal resistance $R_i$ in thermoelectric conversion element also decreases and life of durability for TCE is improved. As in the cooling operation, value of Ri in TCE can be reduced, so that the reduction of Ri not only can decrease endothermic amount, but also can decrease the amount of absorption energy by $R_i(I_{ac})^2$ /2. If the current of working substance contains a component of alternate current part $I_{ac,}$, the thermoelectric performance of TCE is improved more at the same power supply with the same ripple ratio, which is the ratio of AC component to DC power supply.

Claim 1 relates to TCE in which the surface 13 is in face to face with the terminal 14 in Space in Fig. 1. Even if the above described method is used, working substance hardly move through the space 12, or the amount of working substance flow does not reach those in the thermoelectric materials 10 and 11 which nip the space 12. In this case, by bridging with a conductor for working substance 63 across between thermoelectric materials or between thermoelectric material and electrode 60 and 61 in Fig. 6. The amount of working substance flow by bridging can get to or more over than those in thermoelectric materials 60 and 61 or thermoelectric material and electrode without bridging. And with suppressing the heat flow by bridging with a larger bridging material than $L_{max}$ (T), it is possible to obtain a larger amount of working substance flow than that of working substance flow in Space. By using the structures that a conductor for working substance 63 in Fig. 6 are in column with diameter of a few nano meters in Fig 4a, in hollow cylinder with wall thickness of a few nano meters in Fig 4b or in flat board whose at least one side of cross section is perpendicular to working substance flowstream is in a few nano meters in Fig 4c, phonon scattering on the surfaces which are not the cross section representing a wall thickness becomes significant compared to the effect of phonon scattering at the other surfaces. Further working substance is scarcely scattered except for the surfaces parallel to working substance flowstream, and if the surfaces which are not parallel to working substance flowstream are in minute not to scatter working substance much, then the amount of working substance flow is enlarged working substance flow is subject to the influence of the special dimension. In the case that the amount of working substance flow in a bridging material 63 is smaller than those in the thermoelectric materials or electrode, cross sectional area of the bridging material 63 made from a conductor for working substance are enlarged, otherwise in the space 62 number of the fine structures which are made from a conductor for working substance is increased (hereinafter, the space cross-linked with fine structures is abbreviated as Bridging Space). In the hollow cylindrical shape and the flat board of the wall thickness of a few nanometers (Fig 4b and c), the amount of working substance flow is less than that in the column (Fig.4a), but is better than that in the bulk in spatial three dimension. It is characteristic for the claim 2 that the thermoelectric performance of TCE is increased by the fact that Bridging Space, in which cross-linked with fine structures across the space 62 between thermoelectric materials 60 and 61 as shown in Fig. 6 is included in TCE.

The amount of working substance flow, through the thermoelectric materials or the structures made of either combination of the column in Fig. 4a and the hollow cylindrical shape in Fig. 4b or combination of flat boards in Fig. 4c whose cross sectional views of Fig. 5a are for the former and that of Fig. 5b for the latter, is not smaller and moreover the combinational cross section must be large not to be less than that of working substance flow through the thermoelectric material without the fine pillar structure as shown in Fig.4. Hereafter, this type of the bridging structure in Bridging Space is abbreviated as Fine Structure, for simplicity. The figure of merit in Math. 1 can enlarge through increase of phonon scattering on the interfaces of the layered structures in Fine Structure without reducing of the amount of working substance flow in the layered in which a mobility of working substance is high. By addition, through portions, to which portions of high mobility of working substance are adjacent, made from materials of low mobility of working substance having a thickness in which working substance is not transmitted in a radial direction, the amount of working substance flow through Fine Structure over all increases so that it is possible to increase the value of the figure of merit of Math. 1, In case of length of Fine Structure 63 being short, phonon motion is in ballistical one so that the thermal conductivity of Fine Structure is high, and then the figure of merit decreases. In case of the length being long, it is possible by using Fine Structure made from thermoelectric materials to increase not only the electromotive force generated in Fine Structure but also the figure of merit enlarge by the generated electromotive force therein.

In the case that the length of Fine Structure is longer than that of the mean free path of phonon, the thermal conduction obeys Fourier's law. The length is shorter, the phonon motion becomes more ballistic one that makes thermal conduction increase so that the thermoelectric performance of TCE including Fine Structure is worse. In Fig.6 in the interface between Fine Structure 63 and either 60 or 61, densities of lattice dislocations, impurities and defects are as low as possible so that the amount of working substance flow closes to or enlarge more than those of the thermoelectric materials 60 and 61 without Bridging Space as large as possible. In order for the amount of working substance flow through Fine Structure to surpass those of the thermoelectric materials without Bridging Space, many bridging materials of Fine Structure are introduced in the space as shown in Fig. 7.

Electric current is carried by the classical and quantum working substances. Heat is transferred round by incidents accompanied with working substance causing electric power, by lattice vibrations, by radiation and so on. In the case that the width of the space is narrow, or that the space is bridged across by the fine structure, the quantum working substance can be utilized at cryogenic temperatures. Hereafter, for simplicity, the space bridged across by the fine structure is abbreviated as Bridging Space as before. In case of magnetic field applying to thermoelectric materials, by Hall effect and Nernst effect and the resistance of working substance applying to working substance flowstream, directions of heat transfer and electric current and that of gradient of voltage are not in the same direction. A width of Bridging Space for lattice vibration being larger than $L_{max}$ (T), and Bridging Space and Space established to prevent heat transfer except for the heat accompanied with working substance flow make the thermoelectric performance of TCE improve.

In the case that the terminal of the thermoelectric material 81 facing and in contact with the space 82 is irradiated by electromagnetic field including light and radiation, those energies are applied to working substance. And working substance is in higher surface energy states, then the energy that working substance goes over the potential barrier of working substance into the space 82 decreases.

The width of the potential barrier which working substance tunnels through, moreover, is reduced. Otherwise working substance in the terminals of thermoelectric materials can take in energy states of working substance easily running away from the terminals of the thermoelectric materials. Radiation serves to mainly help the movement of working substance from the terminal releasing working substance to the terminal receiving working substance. Claim 3 represents that energies from the sources of electromagnetic fields and of radiation arranged in 82 in Fig. 8 supply to working substance moving through the space 82, working substance getting away in the space 82 from the terminal releasing working substance and the terminal of the material 81 from which working substance releases so that working substance can conduct easily through the space 82. The radiation sources can also be embedded in the terminal of 81 of the materials or the terminal of 80 facing the terminal of 81 from which working substance releases. In the case that the radiation sources are either placed in the vicinity of or embedded in the terminals, it is possible to utilize the heat by radiative decay. In case of using light, working substance emitting surface can be irradiated by the light guided into 82 through glass fiber. Otherwise, it is able to reach light at the terminal near the center of 82 by enlarging larger the distance between the outside ends of confronting terminals in the space 82. It is also possible to include the effect of field emission by the steeple built on the terminal 81 in FIG.8.

In TCE including Space or Bridging Space, the mobility of working substance is not uniform with respect to location and time of working substance motion. At an interface where inflow and outflow of charge possessed by working substance is different from each other, the outflow or inflow charges possessed by working substance at the interface is much accumulated and the accumulated charge prevents working substance from moving through the interface. And working substance having charges stores up at the interface, then deterioration of TCE occurs. Claim 4 is characteristic of getting the effect that the locally stored charges are diffused by coating the surface receiving or releasing working substance with good conductors for working substance. The coating of the thin films of good conductors strengthens the quality of TCE or reduces less degradation due to preventing from concentration of heat on the surface and the amount of energy obtained per unit time is increased. By coating the surface accepting or releasing working substance with the good conductors, the potential barriers for working substance moving from the terminal to the other thermoelectric material, which is based on working substance concentration difference between on the receiving or releasing surface or terminal and on the inner part of thermoelectric material, decrease or the fracture of TCE based on shortage or excess of working substance concentration is reduced.

In case of TCE having Space, local impingement and mechanical destructions due to working substance moving across Space make the deterioration of the terminals or the surfaces take place. Further, by encapsulating the metal vapor or gas in the space, and the energy state of working substance changes due to collisions between working substance and the atom or molecule, or by the collision between working substance in the space. Claim 5 is characteristic of coating or uniting the surface with other materials whose forces between their constitutional atoms of the other materials are stronger than those of the uncoating or ununiting surface or in which cooperative motions of their constitutional atoms occurs in order to eliminate the thermoelectric material failure except friction in the surfaces which working substance has tunneled through or received. Alternatively it is possible to prevent deterioration of TCE by absorbing vibration where the cage-structured compounds is used in working substance receiving terminal.

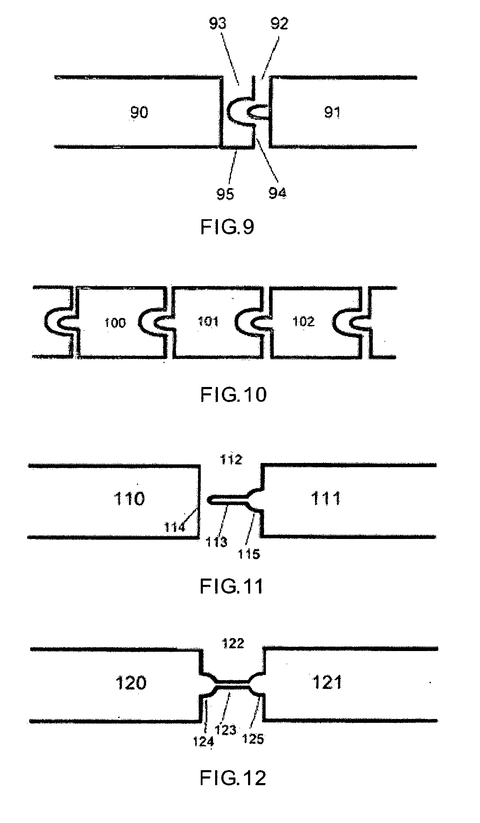

In TCE made from the functionally graded materials (FGM) whose electron density due to doping impurities is controlled to continuously change along gradient of the temperature over the working temperature range by Space and Bridging Space constructed in FGM, the thermoelectric performance of TCE can be larger than the figure of merit of a thermoelectric material made from uniform constitution. In case of combination of some TCEs, the concept of thermoelectric performance is different each other according to the intended use. Metal parts such as electrode and so on of TCE also have an influence on the thermoelectric performance. In case that Space in TCE are formed in thermoelectric materials including, by adjusting the distance between the facing end faces of Space and altering the size of Space or by changing the shape of the facing end faces, working substance can move through the space and the heat transfer without the heat transfer of working substance can be reduced. Because that TCE are made from thermoelectric materials segmented by using Space or Bridging Space, Due to FGM by use of Space or Bridging Space, claim 6 is characteristic of the system configuration which is changed as same as the system creation by conjugation both with the absence of defects in the device creation by conjugation and with the influence of performance degradation due to the diffusion of the components of the electrode material or a thermoelectric material being small. As shown in Fig. 9 the distance between the surface releasing and the surface accepting working substance can be changed the gap distance between 94 and the facing end by actuator to adapt to the various temperature range.

In case of combining many segmented thermoelectric materials into one with Space or Bridging Space, an endurance of thermoelectric systems is determined by fatigues due to thermal stress through temperature distribution at interfaces between thermoelectric materials or electrodes and between segmented thermoelectric materials, through thermal expansion of Space and Bridging Space and through thermal fluctuations of thermal reservoir during operation due. It has been reported that contact resistances between thermal materials or electrodes increase and that as a result burnout due to Joule heat from cracks of the fatigues occurs. The mechanical damages can be prevented from the thermal expansion by providing Space or Bridging Space in the thermoelectric material. Because of the width of the space in Space being larger than $L_{max}\ (T)$, destructions due to quantum fluctuations especially at cryogenic temperature, due to thermal stress at the interfaces through fluctuations of temperature during operation and due to substances except working substance moving through the interfaces occurring in operation can be suppressed.

The wider the temperature difference between the high and the low temperature parts, the more the number of Space in TCE can be. On the other hand, regardless of the temperature difference being wide or narrow ranges, the more the number of Bridging Spaces is, and then the less additional energy losses except the radiational loss can decrease in TCE.

For power generation of thermoelectric materials in the wide temperature difference between the hot and the cold parts, the electromotive force can be increased by the method of constituting many Spaces in TCE. As shown in Fig. 10, TCE is composed of many segmented thermoelectric materials or Conductors. In this case, both heights of nano meter sized pillar or coils made of thermoelectric materials or Conductors formed on the terminal 101 in TCE and the radii of curvature of the nano meter sized structures of the surfaces releasing working substance have influence on deformation from bulk density of states for working substance in thermoelectric materials or Conductors on working substance transforming in thermoelectric materials or Conductors including Spaces, but these heights and the radii of curvature, the areas of the surfaces releasing working substance such as the tip of the nano meter sized pillar and coil structures including the side of the coil, the optimum distance between the tips or the most curve-in point and the optimum number of Space are determined as followorking substance. By approach from sub-micro meter and larger than $L_{maX}(T)$ to $L_{max}(T)$ the width of distance between the ends of Space is decreased, as in concrete expression of the power generation operation, the amount of working substance flow in Space more increases as in the following,

1) In the case that the distance between the surface of either the steeple tip or the steeple and its facing terminal is larger than $L_{max}(T)$, the thermal transfer by use of phonon can be negligible small in Space. $L_{max}(T)$ has relation to the force between atoms constituting the surface and its facing terminal, and is determined from the actual measuring range of distance between the atoms of needle of atomic force microscope which are ones of the above surface and its target surface which are ones of the terminal. $L_{max}(T)$ can be compensated by taking account of thermal expansion, fluctuation of thermal source and quantum fluctuation especially in cryogenic temperature.

2) During operation, an enhanced electric field near convex surface of either the steeple tip or the steeple in Space is approximated the electric potential difference divided by the distance between the surface of either the steeple tip or the steeple and its facing terminal by multiplying the enhancement factor β, which is the height of either the steeple tip or the steeple divided by the radii of curvature of the surface. Otherwise, the enhanced electric field is determined by numerical simulation. The difference of the electric potentials between the surface and its facing terminal is also affected by electromotive force yielded by the thermoelectric materials or Conductors on either side of the space.

3) The amount of working substance flow through Space due to thermal excitation of working substance, quantum fluctuations in cryogenic temperature and tunneling, depends on working substance emission area and the direction of working substance flowstream. And in the terminal that receives working substance, the bulk density of states for working substance depending on the direction of momentum of working substance flowstream changes from pre-infusion, so that the changes for the density of states have influences on microscopic electric and thermal conductivities. In the case that the bodies of either the steeple tip or the steeple are exchanged by the thin fine or the pillar-structures with diameter in a few nanao meters, the changes for physical character of the structures improves the performance in Space. The closer the amount of working substance flow in Space reaches that of either side of thermoelectric material or Conductors by optimizing the spatial deformed form of terminal receiving working substance in Space and the distance between the surface of either the steeple tip or the steeple and the most curve-in point of the terminal so as to satisfy the above 2). By the method of above devising, working substance flow through the space can smoothly and effectively occur.

4) In the case that the amount of working substance flow through a single either steeple tip or steeple into Space can not reach that of either side of thermoelectric materials or Conductors, many either tips of the steeples or steeples as shown in Fig. 2 can be arranged so as to enlarge that of working substance flow in Space. Many either tips of the steeples or steeples are condensely arranged on the terminal releasing working substance so that the effect of the enhancement factor b greatly decreases. The shape of the surface for either the tips of the steeples or the steeples and the surface density of states of them are optimized so as for the amount of working substance flow due to field emission of working substance to be larger than of that before working substance flow which has not divided by many either tips of the steeples or steeples, or to reach that that of working substance flow in the thermoelectric materials or Conductors without Space as large as possible. Suitable distance between the ends of Space is appropriately determined in this manner.

Because of a wide temperature range in operation, in the case that the amount of working substance flow in the thermoelectric materials or Conductors with one Space is larger than that of working substance flow of the bulk thermoelectric materials or Conductors without Space or that working substance flow through the field emission of working substance due to the effect of the enhancement factor reaches as large as possible or enlarges more than that of either side of thermoelectric material, the contrivance means from 1) to 4) is applied to other Spaces in first divided the thermoelectric materials or Conductors into two thermoelectric material. From above result, if Spaces are optimized including the shape of the electrode terminals more than one, additional energy loss, except for the emission of radiation energy loss due to the difference temperature between the facing ends to each other in each Space, can decrease drastically. In generation of electric power when the temperature difference between the high and the low temperature parts is narrow, the distance between the surface of either the steeple tip or the steeple and the terminal can not be optimized as before. In this case, Bridging Space in Fig. 6 is used. In operation of cooling system external voltage or current are applied as occasional demands. As TCE is manufactured by above described process, even if figure of merit of the thermoelectric materials is the highest, the thermoelectric performance of TCE made from them is more drastically improved. Moreover, the operation of cooling system is a reversible process of the generation of electric power so that the thermoelectric performance of TCE manufactured in above method is improved drastically even in the operation of cooling system.

Thermoelectric material group in Fig.10 is not necessary to be manufactured as shown in the order of number, and all the numbered thermoelectric materials are not necessary to manufacture TCE. Further like π-shaped modules made of a pair of different polarities that is p-type and n-type, a group of thermoelectric materials such as the group of π-shaped modules can be manufactured in parallel independent of the other groups so that the π-shaped modules may as well be manufactured independently in parallel. In addition, many π-shaped modules, which are grouped in a series, in a parallel, in the mixture combination of series and parallel or in hybrid parallel with the series of π-shaped module, are taken in a system. As an example, it is expressed that the system consists of many hybrid type of π-shaped modules, which are grouped in a series, in a parallel or in mixture combination of series and parallel of π-shaped module, thermoelectric combination modules made of thermoelectric materials except for the π-shaped modules also are designed according to a scope as well as a spirit of the present invention.

As shown in Fig. 9, instead of changing relative positions between the thermoelectric materials 90 and 91, of moving the terminal of either 90 or 91 or of moving the thermoelectric material either 90 or 91, working substance flowstream is not scattered by the microscopic size structure 94 of good conductor for working substance which is set between the thermoelectric material 90 and the surface of the steeple 96 formed on the terminal of the thermoelectric material 91 and whose shape is large and surrounds than the surface releasing working substance and is like figures of the surface, and the actuator arranged on 95 can help to move in parallel to the shape of the surface releasing working substance. Superimposing alternative currents at the beginning of operation can make a voltage between both ends of the space 92 or the space 92 between the surface 94 controlled by the actuator and the surface of the steeple on the terminal 91 high level, as if the space 92 acts as the condensor space. And then the high voltage can be utilized as a trigger of the initial operation. In case that many Spaces are in TCE, a voltage of an aimed Space can be in high by utilizing CR or CL resonances (or oscillation).

In above explanation, in order to provide a thorough understanding of the various aspects of the claimed invention, the concrete example, such as the distance $L_{max}(T)$, the deformation of the shape for the surface receiving working substance and the shape of both Space where the steeple tip and the steeple is formed and Bridging Space, the coating of the thin films of good conductors and of other thin film materials in which atomic forces in other materials are stronger than those of the terminal and the surfaces because of cooperative atomic motions of the other materials atoms, the actuator, the π-shaped thermoelectric module and the system consisting of the group of various types of the π-shaped modules and of external loads, are explained as a particularly fixed example. Such particular example, however, presents in order to be explained as a way of illustration and are not to be construed as limitations on the claimed invention.

On releasing or receiving terminals for working substance, by configuring a clue 115 such as a tower made of Conductors, it is easy to manufacture the steeple 113 formed on the clues. Fig.11 is an example of applying claim 7 to TCE described by claim 1. At production of the steeple 113 in Space, it is easy to manufacture the steeple due to the clue 115 built between working substance emitting terminal of the thermoelectric materials or conductors 111 and the steeple which has the surface 113 releasing working substance. And then it is possible to produce the steeple of nanometers whose surface emits working substance on the clue of submicrometers. By providing the clue made from Conductors on the terminal 114 receiving working substance, moreover, the amount of working substance flow through the space increases more than that without the clue of Conductors.

Fig.12 is an example of applying claim 7 to TCE described by claim 2. On the thermoelectric materials or conductors 120 and 121, by providing at least one of respective clue 124 and clue 125 being more larger geometrical shape in the direction of working substance flowstream than that of a bridging material 123 of Conductors without clues, the improvement of thermoelectric performance of TCE including the steeple on the clue could be aimed.

The clues 115 in Fig. 11 and 124 and 125 in Fig.12 is rather responsible for controlling the amount of working substance flow through the steeple 113 for the former and the bridging material 123 for the latter tow than primarily responsible for the structure of Space for the former and of Bridging Space for the latter two according to circumstances. It is possible to improve the quality of performance for Space and for Bridging Space because of working substance less scattered within the clues. It is also possible to control working substance flow and heat transfer by coating the surface of the clues with good conductor for working substance without change of scattering ratio for working substance within the clues. Moreover, by connecting directly the terminal receiving working substance 111 with 113 or the bridging material 123 made of Conductors such as 123 with both 120 and 121 within their respective clues, the amount of working substance flow could be increased.

The above explanation, about the example of the π-shaped modules optimumed by maximizing the thermoelectric performance for TCE and of the system embodiments according to principle of the present invention, only adduces one of practicable example as well as one of explanation for the system by maximizing the thermoelectric performance and the optimum for the modules, but does not explain exhaustive optimization and the practicable modes but does not limit the system embodiments by the optimization and the practicable mode designed according to the scope of the present invention. Modifications and variations from the example can be applied in accordance with the teachings of the above instruction, or the changes and the deformations in operation from various modes of the practicable system embodiments for the present invention are obtained. Clearly the method by the fact that TCE is made from thermoelectric materials including Spaces and Bridging Spaces according to the present invention through the claims, and the offer of the π-shaped modules and of the system according to principle of the present invention may be employed in the implementation of a number embodiment according to many practicable modes.

Any types of the actuators, the π-shaped modules and the system which are used in the explanation of the present invention must not comprehend as conclusively important or indispensable to the present invention unless otherwise stated.

Brief Description of Drawings

Fig. 1: Space containing the steeple tip in a thermoelectric conversion element (TCE)

Fig. 2: Space containing the steeple tip and its counter hollow 22 surrounding over the steeple tip 24 in TCE

Fig. 3: Space including many tips of the steeples and their counter terminals 30, 31, 32 and so on surrounding over the tips of steeples in TCE

Fig. 4: Fine pillar structures (Fine Structure) having the wide lateral faces. A column (a) is in the thin structure and (a), a hollow cylinder (b) and a rectangular (c) are in Fine Structure.

Fig. 5: Cross sections of bridging materials made of Fine Structure having layered structures of a cylinder (a) and a rectangular (b)

Fig. 6: Bridging Space containing Fine Structure in TCE

Fig. 7: Bridging Space including plural bridging structures made from Fine Structure

Fig. 8: A space in TCE

Fig. 9: Space having the steeple on the terminal 91 releasing working substance and the surface receiving working substance whose shape 94 is in parallel to that of the surface releasing working substance. The surface receiving working substance is moved by the actuator

Fig. 10: Many Spaces between the multi-stages segmented thermoelectric materials in TCE

Fig. 11: Space has the steeple tip 113 on a clue 115 and the space 112 between the steeple 113 on the clue and the terminal 114 of the thermoelectric material 110

Fig. 12: Bridging Space containing Fine Structure with the fine structure 123 connecting a clue 124 on the thermoelectric material 120 and another clue 125 on another thermoelectric material 121

Reference Signs List

10 The thermoelectric material or the good conductor for working substance having the terminal receiving working substance

11 The thermoelectric material or the good conductor for working substance having the terminal releasing working substance

12 The space

13 The surface of the tip of steeple releasing working substance

14 The terminal of 11 receiving working substance

20 The thermoelectric material or the good conductor for working substance having the surface 22 receiving working substance

21 The thermoelectric material or the good conductor for working substance having the surface 24 releasing working substance

22 The space

23 The surface of the steeple releasing working substance

24 The surface of the the terminal receiving working substance

30, 31, 32 The steeple structure receiving working substance

60 The thermoelectric material or the good conductor of working substance

61 The thermoelectric material or the good conductor of working substance

62 The space

63 The bridging material made from Fine Structure

70 The thermoelectric material or the good conductor for working substance having the terminal receiving working substance

71 The thermoelectric material or the good conductor for working substance having the terminal releasing working substance

72 The space

73 Many bridging materials made from Fine Structure

80 The thermoelectric material or the good conductor for working substance having the terminal receiving working substance

81 The thermoelectric material or the good conductor for working substance having the terminal releasing working substance

82 The space

90, 91 The thermoelectric material or good conductor of working substance 92 The space

93 The space between the terminal of 90 and the surface similar and parallel to the surface of the steeple

94 The similar and parallel surface to the terminal of the steeple

95 The material sustaining the width between the surface of the steeple and the similar and parallel to surface 94 being able for working substance to transfer through the space 92

100, 101, 102 Elements of TCE having segmented structures made from the thermoelectric material or Conductors

110 The thermoelectric material or the good conductor for working substance having the terminal receiving working substance

111 The thermoelectric material or the good conductor for working substance having the surface 113 releasing working substance

112 The space

113 The steeple releasing working substance

114 The terminal accepting working substance

115 The clue such as a tower on which the steeple usually stands

120 The thermoelectric material

121 The thermoelectric material or the good conductor for working substance

122 The space

123 The bridging material made from Conductors

124, 125 The clue

## Claims

1. A thermoelectric conversion element comprising;
one or more spaces between a terminal of thermoelectric material and another material facing each other: the one or more spaces disturbing heat transfer and working substance flow, wherein
in these spaces, the widths of these spaces being larger than the width in which the heat transfer amount except for that due to the working substance being almost negligible, but the amount of the working substance flow being equivalent to or more than the amount of the working substance in original thermoelectric materials,
by building some special shapes of structures on ends of those spaces, particles in electric field or in magnetic field, in the concentration diffusion field or in Josephson junction being easily released from their respective shape of structures, more reduction of thermal conductivity, of thermal stress damage or for the diffusion mixing of the material ions being yielded, and
moreover and utilization of the heat generated by the movement of the working substance through the terminals or the surfaces.

2. A thermoelectric conversion element comprising;
one or more spaces between a terminal of thermoelectric material and another material facing each other: the one or more spaces disturbing heat transfer and working substance flow, wherein
by bridging across ends of more than one space by use of more than one either thin or fine structure, not only amount of the working substance flow in the either thin or fine structures being equivalent to that of the flow in the thermoelectric materials adjacent to the space, but also that of the heat transfer except for the heat transfer due to the working substance being reduced through more than a length of the either thin or fine structures which is longer due to phonon scattering by use of more length than the least length of the either thin or fine structures, and reducing the diffusion mixing of the material ions as well as the damage due to thermal stress or by reducing the thermal conductivity compared with those of thermoelectric materials without spaces.

3. The thermoelectric conversion element according to claim 1 or 2, wherein,
the space has a radiation source or an electromagnetic source near the terminal of the thermoelectric materials and so on in at least one of spaces, so that an amount of electric current due to the working substance is equal to or more than that of the working substance in original thermoelectric materials adjacent to space, and

then being **characterized in that** the thermal conductivity in the thermoelectric conversion element is reduced compared with the case of those of original thermoelectric materials without Space and Bridging Space.

4. The thermoelectric conversion element according to claim1, claim 2, or claim3, wherein,
in that surfaces or terminals of the thermoelectric materials adjacent to Space and Bridging Space are covered with coating of the good conductor for the working substance or bonded with materials that prevent local electrification from staying near-by the surfaces or the terminals.

5. The thermoelectric conversion element according to claim1 and claim3,wherein
being covered with coating or bonded with materials on the surfaces or the terminals of the thermoelectric materials adjacent to Space or Bridging Space
and then being **characterized in that** the surfaces hardly deteriorate even though a large amount of electric current or the working substance flow.

6. A thermoelectric conversion module and a thermoelectric conversion system with a built-in-them being **characterized in that**
it is easy to design as a segmented element by made from the thermoelectric conversion element having movable parts in Space or among the thermoelectric conversion elements according to claim1, claim 2, claim3, claim 4 or claim 5.

7. From the parts being not in Space, to base ports of the special shape of structures, from whose surface the working substance is easily released in the space according to claim 1or at end ports of the either thin or fine structures in Bridging Space according to claim 2, the thermoelectric conversion element being characterized as adding to the ports, in the perpendicular directions to the direction of the working substance flowstream, clues from whose shape the working substance is easily released by the above mentioned fields or larger salient bodies or the either thin or fine structures compared with the above mentioned either thin or fine structures.

8. A thermoelectric conversion module being made from both the thermoelectric conversion modules according in claim 6 and the thermoelectric conversion elements according to claim 1, claim 2,claim 3, claim 4, claim 5 and claim 7,
and a thermoelectric conversion system being incorporated into by the thermoelectric conversion modules and the thermoelectric conversion elements.

FIG.1

FIG.2

FIG.3

FIG.4

a                          b

FIG.5

FIG.6

FIG.7

FIG.8

FIG.9

FIG.10

FIG.11

FIG.12

## INTERNATIONAL SEARCH REPORT

| | International application No. |
|---|---|
| | PCT/JP2012/071529 |

**A. CLASSIFICATION OF SUBJECT MATTER**
*H01L35/32*(2006.01)i

According to International Patent Classification (IPC) or to both national classification and IPC

**B. FIELDS SEARCHED**

Minimum documentation searched (classification system followed by classification symbols)
H01L35/32

Documentation searched other than minimum documentation to the extent that such documents are included in the fields searched

| Jitsuyo Shinan Koho | 1922–1996 | Jitsuyo Shinan Toroku Koho | 1996–2012 |
|---|---|---|---|
| Kokai Jitsuyo Shinan Koho | 1971–2012 | Toroku Jitsuyo Shinan Koho | 1994–2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2004-515924 A  (International Business Machines Corp.),<br>27 May 2004 (27.05.2004),<br>entire text; fig. 2, 6 to 7, 12, 15 to 16<br>& WO 2002/047176 A2 | 1-3,6-8<br>4-5 |
| Y | JP 2011-514659 A  (Northrop Grumman Systems Corp.),<br>06 May 2011 (06.05.2011),<br>paragraph [0074]<br>& WO 2009/099709 A2 | 4-5 |
| A | JP 2009-520361 A  (The Boeing Co.),<br>21 May 2009 (21.05.2009),<br>entire text; fig. 2<br>& WO 2007/081483 A2 | 1-8 |

☐ Further documents are listed in the continuation of Box C.　　☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 19 November, 2012 (19.11.12) | 27 November, 2012 (27.11.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20050016575 A1
- JP 2009021593 A
- JP H0955542 A
- JP H1027927 A
- JP H1041554 A
- JP 2007246326 A

### Non-patent literature cited in the description

- *Phys. Rev. B,* 1993, vol. 47, 16631
- *Jpn. J. Appl. Phys.,* 2008, vol. 47, 2005
- **POUDEL, B. et al.** High-Thermoelectric Performance of Nanostructured Bismuth Antimony Telluride Bulk Alloys. *Sience,* May 2008, vol. 320 (5876), 634-638
- *Jpn. J. Appl. Phys.,* 2009, vol. 48, 098006
- *Appl. Phys.,* 1962, vol. 33, 2917
- **J. P. FLEURIAL ; G.J.SNYDER ; J.A.HERMAN ; P.H.GIAUQUE ; W.M.PHILLIPS ; M.A. RYAN ; P.SHAKKOTTAI ; E.A.KOLAWA ; M.A.NICOLET.** *18th International Conference on Thermoelectrics,* 1999